## Europäisches Patentamt

## European Patent Office

## Office européen des brevets

(19)

(11) Veröffentlichungsnummer: **0 116 659
B1**

(12) **EUROPÄISCHE PATENTSCHRIFT**

(45) Veröffentlichungstag der Patentschrift:
17.09.86

(51) Int. Cl.⁴: **B 29 C 63/02,** G 03 F 7/16

(21) Anmeldenummer: **83101541.7**

(22) Anmeldetag: **18.02.83**

(54) **Einrichtung zum beiderseitigen Aufbringen von Folien oder dergl. auf plattenförmige Werkstücke und Verfahren zum Betrieb derselben.**

(43) Veröffentlichungstag der Anmeldung:
**29.08.84 Patentblatt 84/35**

(45) Bekanntmachung des Hinweises auf die Patenterteilung:
**17.09.86 Patentblatt 86/38**

(84) Benannte Vertragsstaaten:
**DE FR GB IT**

(56) Entgegenhaltungen:
**EP - A - 0 085 793
CH - A - 470 963
GB - A - 27 173
US - A - 3 658 629
US - A - 4 025 380**

(73) Patentinhaber: **IBM DEUTSCHLAND GMBH,
Pascalstrasse 100, D-7000 Stuttgart 80 (DE)**

(84) Benannte Vertragsstaaten: **DE**

(73) Patentinhaber: **International Business Machines
Corporation, Old Orchard Road, Armonk, N.Y. 10504 (US)**

(84) Benannte Vertragsstaaten: **FR GB IT**

(72) Erfinder: **Bradler, Hans-Joachim, Brauereistrasse 36,
D-7031 Magstadt (DE)**
Erfinder: **Brauner, Wilfried, Taunusstrasse 57,
D-7033 Kuppingen (DE)**
Erfinder: **Deyhle, Manfred, Panoramastrasse 22/1,
D-7031 Hildrizhausen (DE)**
Erfinder: **Vogt, Karl-Heinz, Dolomitenstrasse 2,
D-7033 Herrenberg (DE)**

(74) Vertreter: **Brügel, Gerhard, Dipl.-Ing., Schönaicher
Strasse 220, D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft eine Einrichtung zum beiderseitigen Aufbringen von Folien oder dgl. auf plattenförmige Werkstücke mittels eines Paares von drehangetriebenen Laminierwalzen, zwischen denen die Werkstücke aufeinanderfolgend hindurchgeführt werden, während die Folien als Bahnen mittels eines Paares an Unterdruck angeschlossener Zuführelemente zugeführt, mit ihrer Leitkante am Werkstück angeheftet und auf ihre Abschnittslänge abgeschnitten werden, sowie ein Verfahren zum Betrieb dieser Einrichtung.

Derartige als Laminatoren bezeichnete Einrichtungen dienen beispielsweise zum Aufbringen von Photoresistschichten auf Schaltungsplatten. Ursprünglich hat man hierzu die von Rollen abgewickelten Folienbahnen, die z.B. aus einer Polyäthylen-Schutzschicht, der eigentlichen Photoresistschicht und einer Mylar-Schutzfolie bestehen, auf die aufeinanderfolgend zugeführten Platten beiderseits fortlaufend auflaminiert und anschliessend die so entstandene Gelenkkette jeweils an den Kanten der Werkstücke aufgeschnitten.

In einer verbesserten Anordnung gemäss der US-PS 3 658 629 ist ein Paar an Unterdruck angeschlossener Trommeln zur Zufuhr der beiderseitigen Folienbahn angeordnet, und Druckleisten am Umfang der Trommeln dienen zum Anheften der Folienbahnen, die nach dem Entfernen der Schutzschicht sodann durch die fortschreitende Trommeldrehung über ihre Länge vom Trommelumfang abgezogen werden. Anschliessend werden die Werkstücke zum festen Auftrag der Folie durch geheizte Laminierwalzen bewegt. Nachteilig bei dieser Ausbildung ist, dass sich die Folie vorzeitig vom Trommelmantel lösen kann und damit die Gefahr besteht, dass sie unkontrolliert auf die Fläche des Werkstücks gelangt und sich dort Falten bilden. Weiterhin können mit diesem Laminator nur einheitliche Folienabschnittlängen geschnitten und somit nur Platten bestimmter Grösse verarbeitet werden.

Eine Verbesserung ist mit einem Laminator erzielt worden, wie er in der US-PS 4 025 380 beschrieben ist. Dort werden die Folienbahnen mittels in einer Schubführung hin- und herbewegter Vakuumschwingen der Vorderkante des erwärmten Werkstückes zugeführt und mit ihren Leitkanten angeheftet, bevor die Laminierwalzen wirksam werden. Positionsfühlschalter lösen sowohl die Schwingen als auch die Schneidvorrichtung aus und können verstellt werden, so dass man unterschiedliche Werkstück- und Folienabschnittlängen verarbeiten kann. Dabei werden die Endkanten der Folienabschnitte nach dem Schneiden über Unterdruckschuhe gezogen und können somit nicht vorzeitig auf die Werkstückfläche gelangen.

Die Arbeitsweise dieser bekannten Einrichtung hat den Nachteil, dass die Werkstücke beim Laminieren nicht kontinuierlich bewegt werden, sondern jeweils angehalten werden müssen, wenn die Folie, deren grösster Teil bereits auflaminiert ist, auf ihre erforderliche Länge abgeschnitten wird. Dieses Anhalten der Platte während des Laminiervorgangs hat häufig eine unerwünschte Vorpolymerisation zur Folge. Denn die Laminierrollen sind geheizt, um ein zuverlässiges Auftragen des Laminats auf die Oberfläche des Werkstücks zu gewährleisten, auch wenn das Werkstück selbst zuvor erwärmt worden ist. Demzufolge tritt beim Stillstand eine unerwünschte konzentrierte Wärmeeinwirkung auf das mit dem Photoresist beschichtete Werkstück auf. Dieser Nachteil wirkt sich um so gravierender aus, je feiner die Leitungsmuster der Platte sind. Im Verlauf der fortschreitenden Miniaturisierung der Schaltungsmuster kommt daher diesem Gesichtspunkt immer grösseres Gewicht zu.

Der Erfindung liegt die Aufgabe zugrunde, eine Einrichtung zum Laminieren von Werkstücken vorgenannter Art so zu gestalten, dass der Prozess im kontinuierlichen Durchlauf der Werkstücke durchgeführt werden kann und damit ein gleichmässiges Verarbeiten der aufzutragenden Folien und eine entsprechende Verbesserung in der Beschichtungsqualität der Werkstücke erzielt wird. Diese Aufgabe ist durch die im Patentanspruch 1 angegebene Einrichtung gelöst worden, wobei das Zusammenwirken der einzelnen Baugruppen und -teile am zweckmässigsten nach den Verfahrensschritten gemäss Anspruch 6 abläuft.

Die Erfindung wird nachfolgend anhand der Zeichnungen in einem Ausführungsbeispiel erläutert.

Fig. 1 zeigt eine schematische Gesamtseitenansicht einer Anlage zum beidseitigen Laminieren von Schaltungsplatten im kontinuierlichen Durchlaufverfahren, und in den

Fig. 2A-2G sind die massgeblichen Bauteile der Laminierstation in ihren unterschiedlichen Positionen im Verlauf der einzelnen Phasen eines vollständigen Laminierzyklus dargestellt.

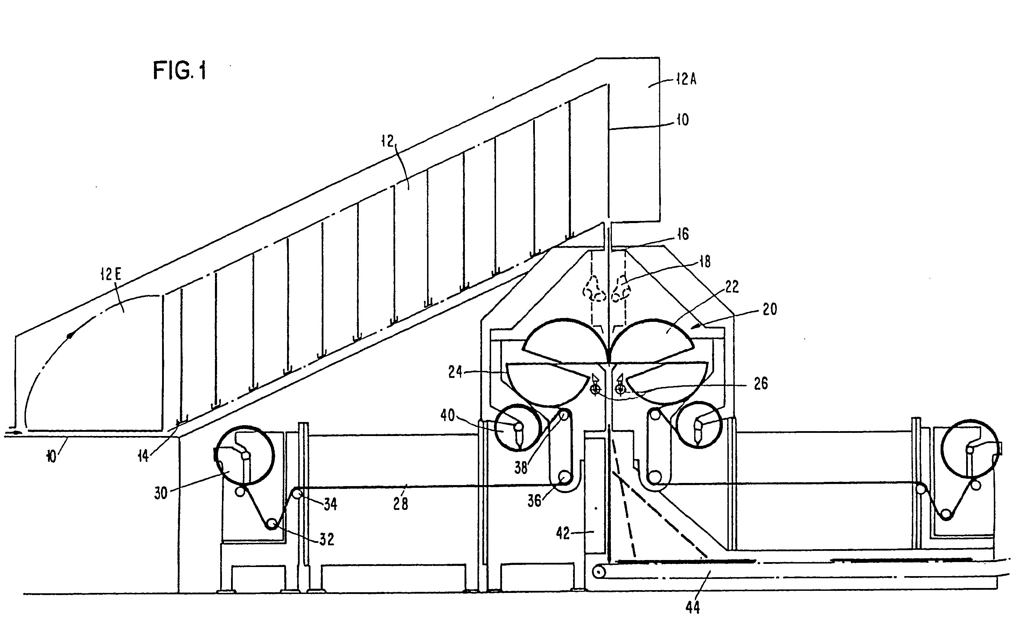

Nach Fig. 1 werden Schaltungsplatten 10, beispielsweise kupferkaschierte, expoxidharzgetränkte Platten in einer Grösse von 500 × 700 mm und einer Dicke von 0,5 mm aus einem Magazin, einem Vorratsstapel oder dgl. einzeln zugeführt und in einen Ofen 12 transportiert, in dessen Eingangsbereich 12E sie aufgerichtet und in dieser Lage mittels eines (in der Zeichnung nur schematisch angedeuteten) Schrägförderers 14 durch den Ofen transportiert werden. Die Temperatur im Ofen 12 und die Durchlaufzeit der Platten 10 sind so bemessen, dass die Platten 10 beim Verlassen des Ofens 12 in dessen Ausgangsbereich 12A eine Temperatur von etwa 120°C haben.

Nach der Entnahme aus dem Ofen 12 werden die Platten 10 in einer Vertikalführung 16 mittels Rollenpaaren 18 abwärts bewegt und gelangen in die Laminierstation 20. Einzelheiten des Aufbaus und der Funktion der Laminierstation 20 werden später beschrieben, an dieser Stelle genügt es, die grundsätzliche Anordnung zu erläutern. Die Platten 10 gelangen zwischen den Zuführtrommeln 22 für die Folie 24 und zwischen den Laminierwalzen 26 hindurch. Je eine Photoresist-Folienbahn 28 wird von Vorratstrommeln 30 über Walzen 32, 34, 36, 38 den Zuführtrommeln 22 zugeführt und auf deren Mantelfläche mittels Unterdruck festgehalten. Hierzu sind in der Mantelfläche der Zuführtrommeln 22 entsprechende Öffnungen vorgesehen, die mit einer Unterdruckquelle verbunden und so auf dem Trommelumfang verteilt sind, dass die Folienbahnen auf ihrer ganzen Breite den Drehbewegungen der Zuführtrommeln 22 folgen. Die von den Vorratstrommeln 30 abgewickelten Folienbahnen 28 bestehen aus einer Photoresistfilmschicht, auf der sich auf der einen Seite eine Polyäthylen-Schutzfolie und auf der anderen Seite eine Mylar-Schutzschicht befindet. Beim Ablauf über die Rolle 36 wird die Polyäthylen-Schutzschicht abgezogen und auf die Trommel 40 aufgewickelt. Es ist darauf hinzuweisen, dass die beschriebene Laminierstation 20 zum beidseitigen Laminieren bezüglich der Vertikalführung 16 der Platte 10 symmetrisch ausgebildet ist, so dass die Beschreibung jeweils für beide Seiten gilt. Wenn die Platten 10 die Laminierstation 20 durchlaufen haben, gelangen sie in einen Auswerfschacht 42, wo sie auf ein Förderband 44 abgelegt und der nächsten Verarbeitungsstufe, z.B. zum Belichten, zugeführt werden.

Die beschriebene Anordnung mit vertikalem Durchlauf der Platten 10 durch die Laminierstation 20 hat gewisse Vorteile, z.B. wegen der Ausnutzung der Schwerkraft beim Transport der Platten. Es ist aber, wenn dies etwa aus räumlichen Gründen günstiger ist, auch eine Anordnung mit horizontalem Durchlauf der Platten denkbar, bei welcher der Ofen vertikal ausgerichtet ist und weniger Fläche benötigt.

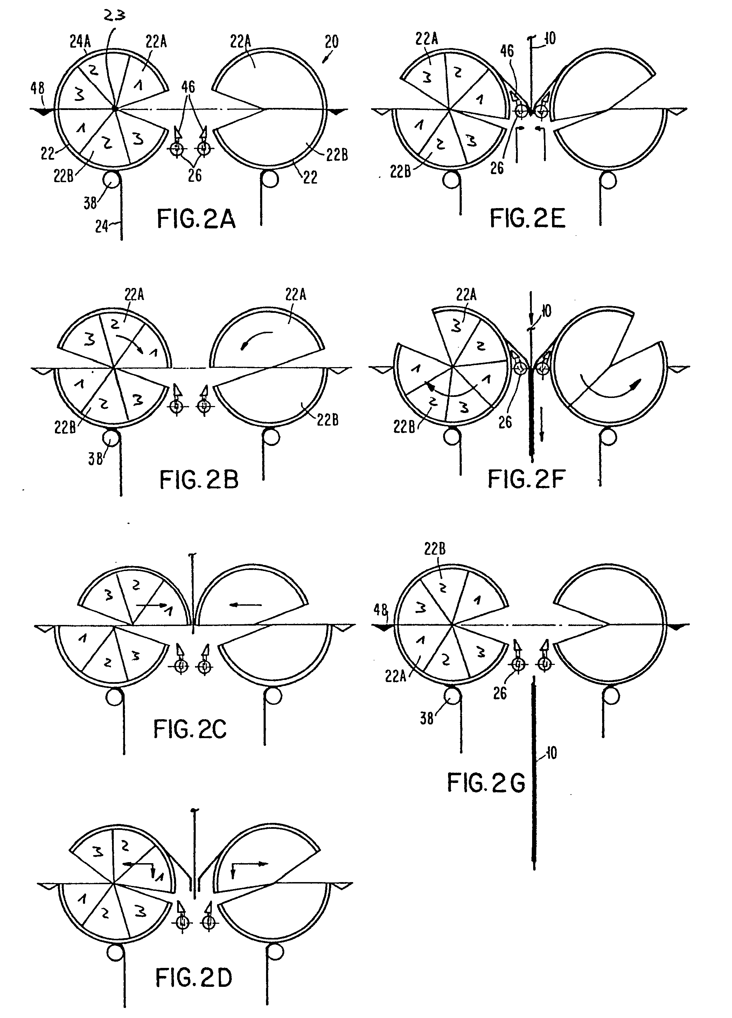

Anhand der Fig. 2A bis 2G werden nun der Aufbau der Laminierstation 20 und die einzelnen Schritte beim Laminiervorgang beschrieben. Hierbei bildet, wie bereits oben erwähnt, die Ebene, in der die Platten die Station durchlaufen, eine Symmetrieebene, und Aufbau und Funktion der einzelnen Teile auf der rechten Seite stimmen mit denjenigen auf der linken Seite überein. Soweit somit im folgenden nur Bauteile und Vorgänge auf der linken Hälfte beschrieben sind, gilt eine solche Beschreibung sinngemäss auch für die rechte Seite der Anordnung. Weiterhin ist anzumerken, dass in den Figuren nur solche Teile dargestellt sind, die am Laminiervorgang unmittelbar beteiligt sind.

Wie die Zeichnungen zeigen, besteht die Zuführtrommel 22 aus zwei gleichen Segmenten 22A und 22B, die unabhängig voneinander radial verstellbar (vgl. Fig. 2C), und in jeder Lage um die Achse 23 der Zuführtrommel 22 drehbar sind. Zwischen den Zuführtrommeln befinden sich die Laminierwalzen 26, die, wie die Pfeile in Fig. 2E zeigen, nach oben und innen verstellt werden können. Die Verstellung sowohl der Trommelsegmente 22A, 22B als auch der Laminierwalzen 26 erfolgt durch in den Zeichnungen nicht dargestellte Antriebsmittel, wie z.B. mittels Elektromagneten in Verbindung mit Kulissenführungen. Oberhalb der Laminierwalzen 26 ist je ein Unterdruckhalteschuh 46 angeordnet, der um die Achse der Laminierwalze 26 so weit schwenkbar ist, dass er die in den Fig. 2A-D und 2G einerseits und die in den Fig. 2E und 2F andererseits dargestellten Positionen einnehmen kann. An der entgegengesetzten Seite der Zuführtrommeln 22 sind an deren Mantelfläche Schneidmesser 48 so geführt, dass sie zum Abtrennen der Folie 24 senkrecht zur Zeichnungsebene bewegt werden können.

Fig. 2A zeigt die Laminierstation 20 in ihrer Ausgangslage nach dem Auswerfen einer laminierten Platte und vor der Zufuhr einer neuen Platte. Die über die Walze 36 zugeführte Folie 24 liegt am Trommelumfang an, und zwar mit ihrer bereits vorher abgeschnittenen vorderen Kante am rechten Ende des Segments 22A gemäss Fig. 2A (2-Uhr-Position). Das Schneidmesser 48 wird nun quer über die Breite der auf der Mantelfläche der Segmente 22A, 22B anliegenden Folie 24 bewegt, so dass ein Folienabschnitt 24A auf dem Umfang des Segments 22A anliegt. Die Folien auf der Umfangsfläche der Segmente 22A und 22B werden durch Vakuum festgehalten, und zu diesem Zweck befinden sich in den Mantelflächen der Segmente 22A, 22B entsprechende Öffnungen, die mit Vakuumkammern in den Segmenten in Verbindung stehen. Jedes der Segmente 22A, 22B ist gemäss der Zeichnung in drei Vakuumkammern aufgeteilt, die in den Fig. 2A-2G durch 1, 2 und 3 bezeichnet sind. Die Segmente 22A und 22B sind austauschbar gegen Segmente mit einem anderen Winkel, und die jeweils verwendeten Segmente entsprechen hinsichtlich ihrer Umfangslänge genau der Länge des zu laminierenden Werkstücks, so dass dementsprechend der abgetrennte Folienabschnitt mit der Werkstücklänge übereinstimmt.

Gemäss Fig. 2B führt das (obere) Trommelsegment 22A nun eine Drehung im Uhrzeigersinn aus, und zwar so weit, dass die vordere Segmentradiusfläche genau horizontal liegt, also die Enden der beiden oberen Segmente 22A auf der linken und der rechten Seite sich gegenüberstehen.

Inzwischen ist die nächste Platte 10 von oben zugeführt worden, und gleichzeitig werden, wie Fig. 2C zeigt, die Segmente 22A nach innen gefahren und drücken die Anfänge der Folienabschnitte 24A von beiden Seiten an die Leitkante der Platte 10. Dabei entsteht infolge der Zusammensetzung der Photoresistschicht, und da die Platte erwärmt ist, eine Klebewirkung.

Anschliessend werden gemäss Fig. 2D die Trommelsegmente 22A wieder zurückgezogen (vgl. grosse Pfeile) und führen hierbei gleichzeitig unter der Zugwirkung der angehefteten Folie eine weitere Drehung aus, wie durch die kleinen Pfeile angezeigt. Dies wird dadurch erleichtert, dass zugleich mit dem Anheften des Folienabschnittes 24A die entsprechende Unterdruckkammer 22A1 der Trommelsegmente 22A abgeschaltet wird, sich die Folie also leicht vom Trommelmantel lösen lässt.

Gemäss Fig. 2E werden nun die Laminierwalzen 26 nach oben und innen verstellt, wie die abgewinkelten Pfeile zeigen, und zwar so, dass sie an der an der Plattenleitkante anliegenden Folie aufliegen. Hierbei wird in den Anstellwinkel der Folie der Unterdruckhalteschuh 46 eingefahren, wodurch die Folie während des nun beginnenden Laminierens unter dem Anstellwinkel gehalten und ein unkontrolliertes Anschweissen an der Platte verhindert wird.

Aus der Fig. 2F ist ersichtlich, wie während des Laminiervorgangs die Folie unter einer gewissen Spannung vom Segment 22A abgezogen und über den Unterdruckhalteschuh 46 geführt wird. Währenddessen stösst das Segment 22A im Verlauf seiner Drehung am Segment 22B an und nimmt, wie der Pfeil zeigt, dieses bei seiner Drehbewegung mit.

Nachdem die Platte 10 laminiert ist, werden, wie Fig. 2G zeigt, die Laminierwalzen 26 mit den Unterdruckhalteschuhen 46 wieder in ihre unwirksame Lage zurückgestellt, und gleichzeitig nehmen die Segmente 22A und 22B wieder ihre Ausgangslage ein, entsprechend Fig. 2A, in der der nächste Folienabschnitt mittels des Schneidmessers 48 abgetrennt wird.

Wie insbesondere die Fig. 2D, 2E und 2F deutlich machen, wird während des Anheftens und Laminierens ein grosser Anstellwinkel der Folie aufrechterhalten, wobei die Spannung der Folie kontrolliert bleibt und ein Abriss der Schweissstelle ausgeschlossen ist. Besonders vorteilhaft ist, dass der Folienabschnitt 24A für das nächstfolgende Werkstück jeweils bereits vor Beginn des Laminierens abgetrennt wird, so dass das Laminieren ohne Unterbrechung gleichmässig durchgeführt werden kann.

## Patentansprüche

1. Einrichtung zum beiderseitigen Aufbringen von Folien oder dgl. auf plattenförmige Werkstücke mittels eines Paares von drehangetriebenen Laminierwalzen (26), zwischen denen die Werkstücke (10) aufeinanderfolgend hindurchgeführt werden, während die Folien (24) als Bahnen mittels eines Paares an Unterdruck angeschlossener Zuführelemente zugeführt, mit ihrer Leitkante am Werkstück angeheftet und auf ihre Abschnittslänge abgeschnitten werden, dadurch gekennzeichnet, dass die Zuführelemente als drehbare, stationär gelagerte Zuführtrommeln (22) mit je mehreren gleichen, austauschbaren Trommelsegmenten (22A, B) ausgebildet sind, deren Umfangslänge der jeweiligen Folienabschnittslänge entspricht und deren Segmentwinkelsumme < 360° ist, und dass die Segmente (22A, B) der Zuführtrommeln (22) unabhängig voneinander radial in Richtung zum Werkstück (10) und zurück verstellbar sowie um die geometrische Trommelachse (23) drehbar gelagert sind.

2. Einrichtung nach Anspruch 1, dadurch gekennzeichnet, dass die Laminierwalzen (26) parallel zur Werkstückvorschubrichtung, nämlich tangential zu der zugeordneten Zuführtrommel (22) sowie radial zur Zuführtrommel in ihrer Wirkstellung verstellbar angeordnet sind.

3. Einrichtung nach den Ansprüchen 1 und 2, dadurch gekennzeichnet, dass den Laminierwalzen (26) je ein um deren Achse begrenzt schwenkbarer Unterdruckhalteschuh (46) zugeordnet ist.

4. Einrichtung nach Anspruch 1, dadurch gekennzeichnet, dass die Bahn der Schneidmesser (48) an der Fuge zwischen dem jeweils wirksamen (22A) und dem daran anliegenden nachfolgenden Trommelsegment (22B) in deren Ausgangslage verläuft.

5. Einrichtung nach Anspruch 1, dadurch gekennzeichnet, dass die Trommelsegmente (22A, B) eine Mehrzahl segmentförmiger, einzeln steuerbarer Unterdruckkammern (22A1, 22A2, 22A3; 22B1, 22B2, 22B3) aufweisen.

6. Verfahren zum kontinuierlichen Betrieb der Einrichtung nach den Ansprüchen 1 bis 5, in der Ausführung mit Zuführtrommeln (22) mit je zwei Segmenten (22A, 22B), dadurch gekennzeichnet, dass

a) die auf den Umfang des jeweils in Arbeitslage befindlichen Segments der Zuführtrommeln (22) zugeführten Folien (24) an den Segmentenden abgeschnitten werden,

b) die betreffenden in Arbeitslage befindlichen ersten Segmente in diejenige Winkelposition gedreht werden, in welcher die Segmentanfänge mit der vorderen Werkstückkante ausgerichtet sind,

c) die ersten Segmente zum Andrücken und Ankleben des Folienanfangs translatorisch zum Werkstück (10) bis zur Anlage am Werkstückanfang verschoben werden,

d) die ersten Segmente zum Abheben der Folie (24) von der Zuführtrommel (22) unter gleichzeitiger kammerweiser Abschaltung des Unterdrucks eine translatorische Rückstell- und gleichzeitige Drehbewegung ausführen,

e) die Laminierwalzen (26) in ihre Wirklage beiderseits der Leitkante des Werkstücks eingestellt werden,

f) die ersten Segmente eine Drehbewegung ausführen und nach Erreichen der Wirkverbindung mit den zweiten Segmenten diese in ihrer Drehrichtung mitnehmen, bis die Folienabschnitte (24A) abgezogen sind, und

g) die Laminierwalzen (26) nach dem Durchlauf des Werkstücks (10) wieder in ihre Ruhelage zurückgezogen werden.

## Claims

1. Device for the two-sided application of foils or similar material on plate-shaped workpieces by means of a pair of rotary driven laminating rolls (26) between which the workpieces (10) are successively guided, while the foils (24) are supplied as webs by means of a pair of vacuum-admitting supply elements, affixed to the workpiece with their leading edge and cut to their segment length, characterized in that the supply elements are designed as rotatable, stationary feeding drums (22) each with several identical, exchangeable drum segments (22A, B), whose circumferential length corresponds to the respective foil segment length, and whose segment angle sum is less than 360°, and that the segments (22A, B) of the feeding drums (22) are adjustable independently of each other and radially in the direction of the workpiece (10), and rotatably supported around the geometrical drum axis (23).

2. Device as claimed in claim 1, characterized in that the laminating rolls (26) are arranged in parallel to the direction of the workpiece advance, i.e. tangentially to the associated feeding drum (22) and arranged in such a manner that they can be adjusted in their operating position radially to the feeding drum.

3. Device as claimed in any one of claims 1 and 2, characterized in that the laminating rolls (26) each have an associated vacuum shoe (46) privotable to a limited extend round their axis.

4. Device as claimed in claim 1, characterized in that the shear blades (48) move along the seam between the respectively active (22A) and the following drum segment (22B) contacting it, in starting position of said segments.

7 0 116 659 8

5. Device as claimed in claim 1, characterized in that the drum segments (22A, B) comprise a plurality of segment-shaped, individually controllable vacuum chambers (22A1, 22A2, 22A3; 22B1, 22B2, 22B3).

6. Method for continuously operating the device as claimed in any one of claims 1 to 5, in the design with feeding drums (22) with two segments (22A, 22B) each, characterized in that

a) the foils (24) fed to the circumference of the respective feeding drum (22) segment in operating position are cut off at the segment ends,

b) the respective first segments in operating position are rotated into that angle position where the front ends of the segments are aligned with the leading edge of the workpiece,

c) for pushing down and fixing the foil front end, the first segments are shifted translatorily toward the workpiece (10) until they contact the front end of the workpiece,

d) the first segments for lifting the foil (24) off the feeding drum (22) execute with a simultaneous chamberwise turning-off of the vacuum a translatory resettging and simultaneously a rotating movement,

e) the laminating rolls (26) are placed into their operating position on both sides of the leading edge of the workpiece,

f) the first segments execute a rotational movement, and after having achieved an operating connection with the second segments, carry these along in their rotational direction until the foil segments (24A) have been lifted off, and

g) the laminating rolls (26) are restored to their stationary position after the workpiece (10) has passed.

**Revendications**

1. Dispositif d'application de feuilles ou similaires sur les deux faces de pièces en forme de plaques à l'aide de deux cylindres de placage (26) entraînés en rotation, entre lesquels les pièces (10) passent les unes à la suite des autres, tandis que les feuilles (24) en chapelet sont acheminées par deux éléments d'alimentation raccordés à une source de vide et fixées sur la pièce par leur bord d'attaque et séparées à la longueur voulue, caractérisé en ce que les éléments d'alimentation sont des tambours d'alimentation (22) rotatifs, montés sur support fixe, comportant chacun plusieurs secteurs de tambours (22A, 22B) semblables, permutables, dont le périmètre correspond à la longueur du tronçon de feuille et dont la somme des angles est inférieure à 360°, et en ce que les secteurs (22A, 22B) des tambours d'alimentation (22) peuvent être déplacés radialement indépendamment les uns des autres pour se rapprocher et s'éloigner de la pièce (10) et peuvent tourner autour de l'axe géométrique du tambour (23).

2. Dispositif selon la revendication 1, caractérisé en ce que les cylindres de placage (26) en position active sont disposés de manière à pouvoir être déplacés parallèlement à la direction d'avance des pièces, à savoir tangentiellement au tambour d'alimentation (22) correspondant ainsi que radialement au tambour d'alimentation.

3. Dispositif selon les revendications 1 et 2, caractérisé en ce qu'à chaque cylindre de placage (26) est muni un sabot à dépression (46) pouvant basculer dans une certaine mesure autour de l'axe du cylindre.

4. Dispositif selon la revendication 1, caractérisé en ce que la trajectoire des couteaux (48) suit la jonction séparant le secteur de tambour actif (22A) du secteur de tambour suivant (22B) en position initiale.

5. Dispositif selon la revendication 1, caractérisé en ce que les secteurs de tambours (22A, 22B) comportent plusieurs chambres à vide (22A1, 22A2, 22A3; 22B1, 22B2, 22B3) en forme de secteurs, pouvant être commandés séparément.

6. Procédé pour le fonctionnement en continu du dispositif selon les revendications 1 à 5, dans son mode de réalisation avec tambours d'alimentation (22) comportant chacun deux secteurs (22A, 22B), caractérisé en ce que

a) les feuilles (24) acheminées sur le pourtour du secteur en position de travail des tambours d'alimentation (22), sont séparées aux extrémités du secteur,

b) les premiers secteurs se trouvant en position de travail sont placés après rotation, dans une position telle que le début des secteurs coïncide exactement avec le bord avant de la pièce,

c) les premiers secteurs servant à presser et à coller le début de la feuille, sont déplacés, par translation par rapport à la pièce (10) jusqu'à buter contre le début de la pièce,

d) les premiers secteurs destinés à enlever la feuille (24) du tambour d'alimentation (22) alors qu'en même temps la dépression est supprimée dans les chambres, exécutent un déplacement de rappel en translation et simultanément en rotation,

e) les cylindres de placage (26) sont réglés en position active des deux côtés du bord d'attaque de la pièce,

f) les premiers secteurs effectuent une rotation et après avoir établi la coopération avec les deuxièmes secteurs, entraînent ceux-ci dans leur rotation jusqu'à ce que les longueurs de feuilles (24A) soient tirées, et en ce que

g) les cylindres de placage sont replacés en position de repos après passage de la pièce (10).

FIG. 1

FIG. 2A

FIG. 2E

FIG. 2B

FIG. 2F

FIG. 2C

FIG. 2G

FIG. 2D